# FASCICULE DE BREVET EUROPEEN

(11) **EP 2 299 324 B1**
(45) Date de publication et mention de la délivrance du brevet: **21.02.2018**
(21) Numéro de dépôt: 10176641.8
(22) Date de dépôt: 14.09.2010
(51) Int. Cl.: G03F 7/00, B29C 33/02

(54) **Moule pour la lithographie par nanoimpression thermique, son procédé de préparation, et procédé de nanoimpression thermique le mettant en oeuvre**
Form für die Lithographie durch thermische Nanoprägung, ihr Herstellungsverfahren und thermische Nanorprägung, bei der sie zum Einsatz kommt.
Mould for thermal nanoimprint lithography, process for fabricating the same, and nanoimprint process using the same.

(30) Priorité: 17.09.2009 FR 0956390
(43) Date de publication de la demande: 23.03.2011
(73) Titulaire: Commissariat à l'Énergie Atomique et aux Énergies Alternatives, 75015 Paris (FR)
(72) Inventeur: Landis, Stefan, 38500, Voiron (FR); Nicoletti, Sergio, 38650 Sinard (FR)
(74) Mandataire: Augarde, Eric

(56) Documents cités:
- EP-A2- 1 726 991
- WO-A1-2004/058479
- US-A1- 2006 279 022

## Description

### DOMAINE TECHNIQUE

L'invention concerne un moule pour la lithographie par nanoimpression thermique ou nanoimpression assistée thermiquement.

L'invention concerne en outre un procédé de préparation de ce moule.

L'invention concerne enfin un procédé de lithographie par nanoimpression thermique qui met en oeuvre ce moule.

### ÉTAT DE LA TECHNIQUE ANTÉRIEURE

Le domaine technique de l'invention peut être défini de manière générale comme celui de la lithographie par nanoimpression (« NanoImprint Lithography » ou « NIL » en anglais).

La lithographie par nanoimpression combine les petites dimensions critiques de la lithographie par faisceaux d'électrons et le rendement élevé de la technologie optique (scanner ou stepper), et constitue donc une technique rentable dans le cadre de la mise en oeuvre d'une lithographie haute définition.

Il existe de nombreux types de lithographie par nanoimpression mais les plus importants sont la lithographie par nanoimpression thermique et la lithographie par nanoimpression assistée par UV.

La lithographie par nanoimpression thermique est la plus ancienne de ces techniques et a été développée par l'équipe du professeur Stephen Chou en 1995.

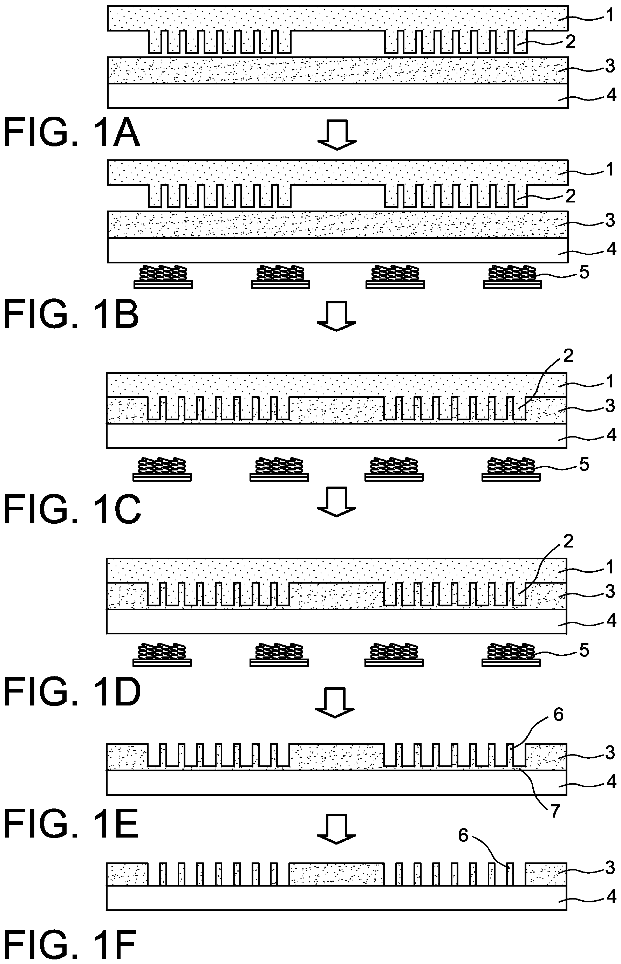

La technique de nanoimpression thermique ou de nanoimpression assistée thermiquement, est décrite sur les figures 1A à 1F. Elle met en oeuvre d'une part un moule rigide (1) généralement en silicium ou en un de ses dérivés (SiO₂, nitrure de silicium ...) ; en polymère ; ou en nickel, comportant en relief les structures, motifs à dupliquer (2) et d'autre part une couche de matériau (3) tel qu'un polymère thermoplastique ou une résine organique déposée sur le substrat (4) à structurer. Le moule est réalisé par des techniques classiques de lithographie ou de gravure.

La couche de matériau (3) est chauffée à une température supérieure à la température de transition vitreuse ou à la température de fusion du matériau, au moyen d'éléments chauffants (5) (Figure 1B) .

On applique ensuite une pression sur la face arrière du moule pour presser celui-ci dans la couche de matériau chauffée (3) (Figure 1C).

A l'issue de ce pressage à chaud, on abaisse la température du matériau en-dessous de la température de transition vitreuse ou de la température de fusion du matériau, par exemple en inactivant les éléments chauffants (5), pour figer les structures imprimées dans la couche de matériau (Figure 1D).

On procède ensuite au démoulage, c'est-à-dire à la séparation du moule (1) du substrat qui porte une couche de matériau imprimé avec des motifs imprimés (6) (Figure 1E).

Enfin, on réalise l'ouverture de l'épaisseur résiduelle (7) qui reste sous les motifs imprimés (6) (Figure 1F).

A l'issue du procédé de nanoimpression thermique, les motifs du moule sont reproduits dans la couche de matériau tel qu'un polymère et peuvent servir de masque de gravure.

On peut ainsi réaliser des motifs de quelques nanomètres à plusieurs microns dans le matériau tel qu'un polymère et par la suite les transférer sur le substrat.

Après plus de dix années de développement, cette technique de lithographie est d'ores et déjà utilisée dans certains secteurs industriels.

Dans la nanoimpression assistée par UV (« FlashImprint Lithography » ou « Photo NanoImprint Lithography ») un moule transparent, par exemple en quartz, est pressé dans une solution de monomères ou un pré-polymère à température ambiante, sous une faible pression. Ensuite les motifs sont figés par photopolymérisation des monomères ou réticulation sous l'effet d'un rayonnement UV. Cette technique connaît actuellement un important développement du fait de la possibilité d'alignement entre différents niveaux avec le moule transparent.

Dans toutes les techniques de nanoimpression, la fabrication des moules est une étape critique, puisque la résolution et le rendement de production en nanoimpression et en nanomoulage dépendent largement de la qualité du moule utilisé.

Dans la technique de nanoimpression thermique, le moule est fabriqué à partir d'un substrat massif en silicium sur lequel des motifs sont fabriqués par les technologies standard de lithographie (optique, électronique, ou aux rayons X...) et de gravure. L'épaisseur de ces moules est généralement dans une plage comprise entre quelques centaines de micromètres et quelques millimètres pour plusieurs raisons :
- d'une part pour permettre leur manipulation et leur positionnement sur les substrats,
- d'autre part, parce que la qualité de surface du moule, réalisé avec des substrats dont l'épaisseur est standard, avec des procédés classiques de micro et nano-fabrication est ainsi garantie et comparable à celle des substrats sur lesquels l'impression sera réalisée.

Comme on peut le constater sur le schéma du procédé de nanoimpression thermique de la figure 1, une étape de mise en température dudit moule ainsi que du matériau à imprimer et du substrat le supportant est nécessaire (Figure 1B).

Typiquement, les températures mises en jeu sont comprises entre 60°C et 250°C. Elles correspondent avantageusement aux températures de transition vitreuse (Tg) ou de fusion (Tf) du matériau à imprimer.

Pour pouvoir assurer une stabilité mécanique suffisante pour démouler, c'est-à-dire pour assurer la séparation du moule du matériau à imprimer, il est alors nécessaire de refroidir l'ensemble en-deçà de la Tg ou de la Tf. Le temps nécessaire pour réaliser ce cycle de température peut atteindre plusieurs minutes voire dizaines de minutes. Compte tenu de la durée des autres opérations associées à la mise en oeuvre de ce procédé, à savoir le couchage du matériau tel qu'une résine, la mise en contact et le pressage, le démoulage, la durée de ce cycle de température limite par conséquent le rendement de ce genre de technologie.

En outre, avec les moules en silicium qui sont généralement mis en oeuvre dans la technique de nanoimpression thermique, l'alignement entre les motifs sur le moule et des motifs déjà réalisés sur la plaque à imprimer est possible mais très difficile.

En effet, le moule en silicium n'étant pas transparent aux longueurs d'ondes visibles, l'alignement nécessite l'utilisation d'une caméra dite à deux objectifs.

Par ailleurs, cet alignement ne peut pas être réalisé lorsque le moule et la plaque à presser sont très proches, car il faut pouvoir positionner la caméra. L'alignement est donc nécessairement effectué lorsque l'écart entre le moule et la plaque à presser est supérieur à quelques centimètres. Cette contrainte limite donc la capacité d'alignement.

Typiquement, on peut espérer obtenir une précision de l'alignement se situant dans une gamme de quelques centaines de nanomètres, ce qui est très insuffisant pour de nombreuses applications. Par conséquent, l'utilisation de moules en silicium limite le champ d'application de la technologie de nanoimpression thermique.

Les moules fabriqués à partir d'un substrat en quartz donnent la possibilité d'aligner les structures à imprimer avec les structures existantes sur la surface de la plaque avant de réticuler le polymère par exposition UV. Mais, la fabrication du moule reste alors problématique car, d'une part les substrats en quartz sont plus chers et plus difficiles à structurer et d'autre part, la maîtrise des procédés de fabrication n'est pas aussi avancée que pour les substrats tels que des plaquettes (« wafers ») en Silicium.

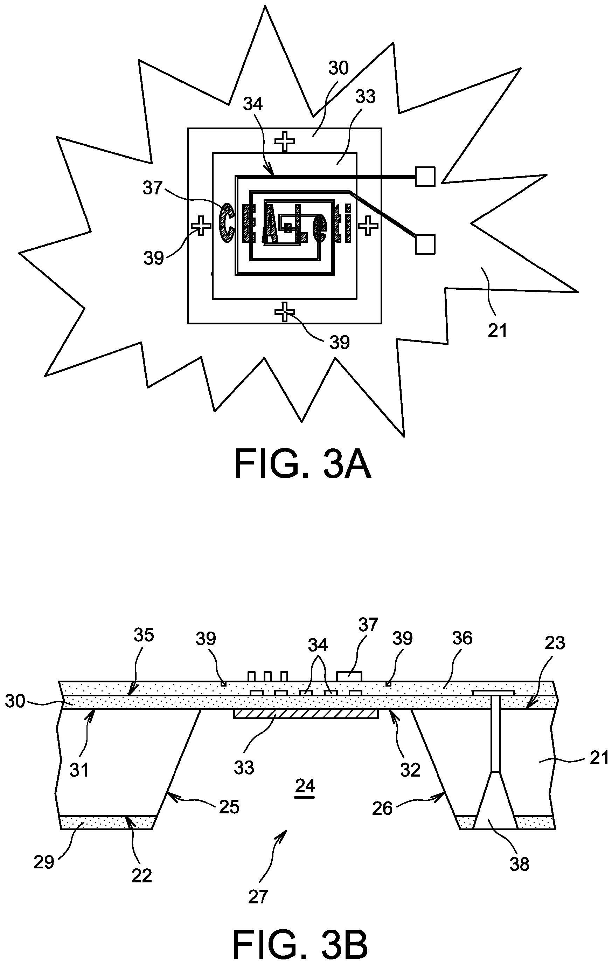

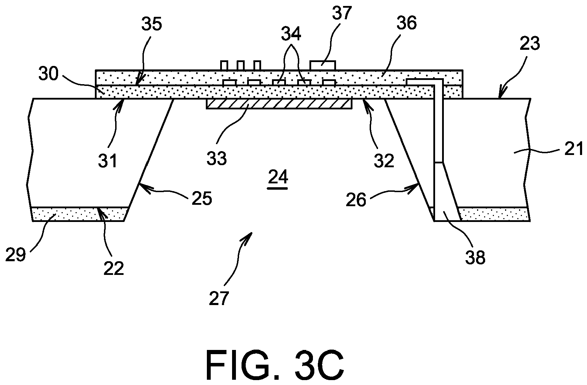

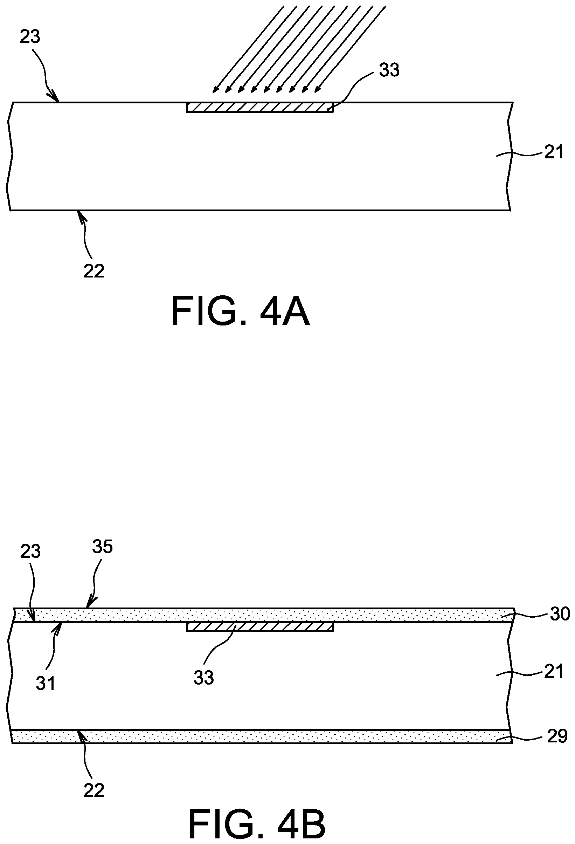

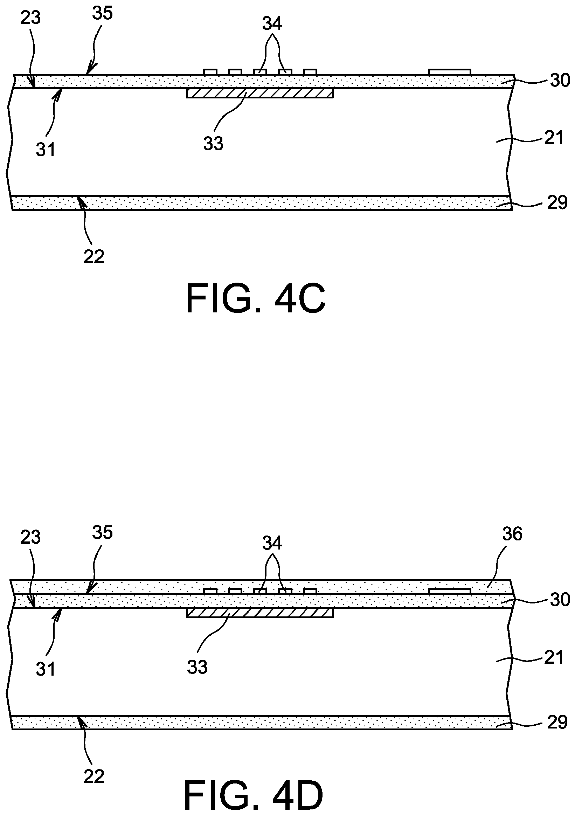

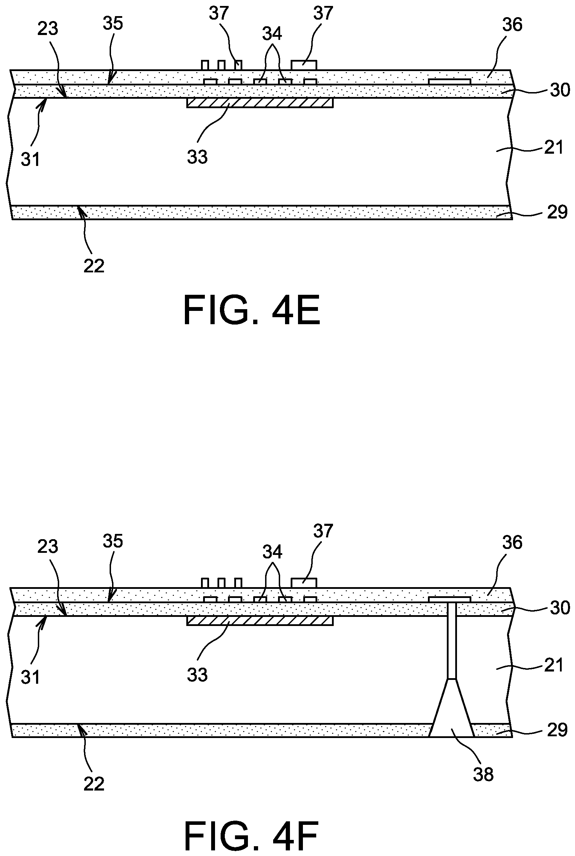

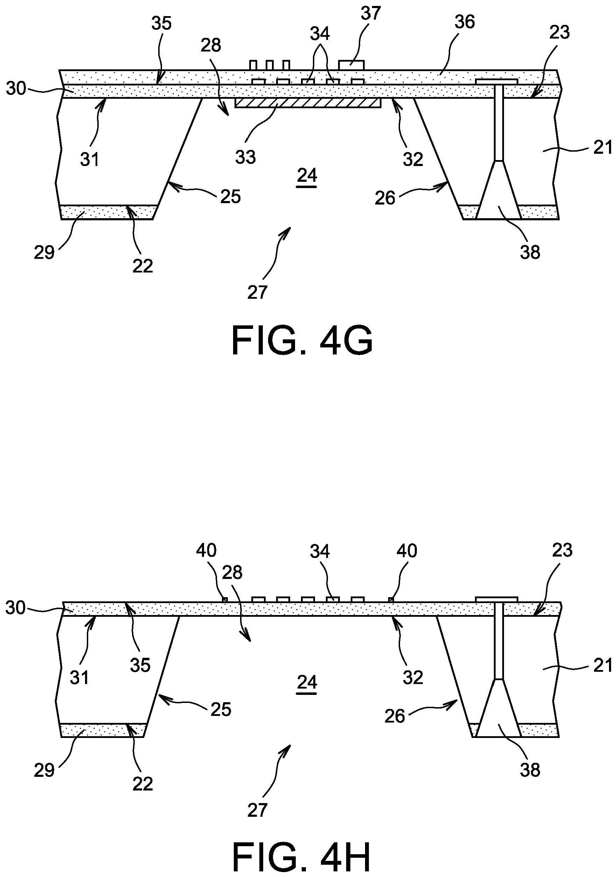

Le document US-A1-2006/0279022 décrit un appareil qui peut être utilisé dans un procédé de nano-impression thermique (Figure 4, paragraphes [0083] et [0084]). Cet appareil comporte un moule chauffant et une pièce de support du moule 250, comportant une cavité obstruée d'un côté par une membrane, dont une face est couverte de motifs à imprimer, et dont l'autre face est pourvue de moyens de chauffage (Figure 3).

Il existe donc, au regard de ce qui précède un besoin pour des moules pour la lithographie par nanoimpression assistée thermiquement ou plus simplement pour la nanoimpression thermique, qui nécessitent un faible apport d'énergie pour atteindre la température de travail, qui présentent une faible inertie thermique et qui permettent de réaliser des cycles de chauffage, montée en température, refroidissement, descente en température, dont la durée soit la plus courte possible, et en tout cas nettement inférieure à la durée des cycles thermiques qui peuvent être réalisés avec les moules existant pour la nanoimpression thermique.

Il existe, en outre, un besoin pour des moules pour la nanoimpression thermique qui soient faciles à fabriquer, faciles à manipuler, de faible volume, qui présentent une excellente qualité de surface et une excellente résolution.

Il existe enfin un besoin pour des moules pour la nanoimpression thermique qui puissent être alignés, positionnés, facilement avec une grande précision par exemple dans la gamme de 10 à 50 nm, à l'instar des moules en quartz, mais sans présenter les inconvénients de ces derniers et sans avoir recours à des dispositifs complexes tels que des caméras à deux objectifs.

### EXPOSÉ DE L'INVENTION

Le but de la présente invention est de fournir un moule pour la lithographie par nanoimpression thermique qui réponde entre autres aux besoins énumérés plus haut.

Le but de la présente invention est encore de fournir un moule pour la lithographie par nanoimpression thermique qui ne présente pas les inconvénients, défauts, limitations et désavantages des moules de l'art antérieur et qui résolve les problèmes des moules de l'art antérieur.

Ce but, et d'autres encore, sont atteints, conformément à l'invention, par un moule chauffant pour la nanoimpression thermique comprenant :
- un substrat (21) comportant une première surface principale (22) et une seconde surface principale (23), et une cavité traversante (24) s'étendant depuis un premier orifice (27) dans la première surface principale (22) jusqu'à un second orifice (28) dans la seconde surface principale (23), ladite première surface principale (22) étant éventuellement au moins en partie recouverte par une première membrane (29) obturant totalement ou en partie ou bien laissant libre ledit premier orifice (27), et ledit second orifice (28) étant totalement obturé par une seconde membrane électriquement et thermiquement isolante (30) reposant par une première de ses faces (31) sur ladite seconde surface principale (23) et recouvrant au moins en partie ladite seconde surface (23) ;
- éventuellement, une couche (33) thermiquement conductrice et de support mécanique de la seconde membrane (30) sur ladite première face (31) de la seconde membrane (30) au-dessus (32) dudit second orifice (28) ;
- éventuellement, une couche thermiquement isolante sous ladite couche (33) thermiquement conductrice et de support mécanique ;
- des moyens de chauffage (34) sur l'autre des faces (35) de ladite seconde membrane (30) dans une zone de ladite seconde membrane (30) au-dessus dudit second orifice (28) ;
- une couche électriquement et thermiquement isolante (36) qui recouvre lesdits moyens de chauffage (34) et au moins partiellement ladite seconde membrane (30) ;
- des motifs à imprimer (37) sur ladite couche électriquement et thermiquement isolante (36) dans une zone de ladite couche électriquement et thermiquement isolante (36) au-dessus dudit second orifice (28);
- des moyens (38) pour amener un courant électrique auxdits moyens de chauffage (34).

Le moule selon l'invention présente une structure nouvelle qui n'a jamais été ni décrite, ni suggérée dans l'art antérieur.

Le moule selon l'invention présente en tant que caractéristique principale un élément chauffant, des moyens de chauffage, intégrés sur une membrane que l'on peut qualifier de « membrane suspendue », qui est destinée à recevoir des structures, motifs qui seront par la suite imprimés dans une couche de matériau tel qu'un polymère ou une résine thermoplastique.

Ces structures, motifs, ont des tailles qui peuvent varier de quelques nanomètres à plusieurs micromètres.

Le moule selon l'invention répond entre autres aux besoins énumérés plus haut pour des moules pour la lithographie par nanoimpression thermique, répond à tous les critères et exigences pour ce type de moule, ne présente pas les inconvénients, défauts, limitations et désavantages des moules de l'art antérieur et apporte une solution aux problèmes posés par les moules de l'art antérieur.

Le moule selon l'invention, du fait notamment qu'il présente un faible volume et que son volume total est réduit et limité à l'ensemble membrane, élément chauffant et nano ou microstructures nécessite un apport d'énergie réduit pour atteindre la température de travail. Le temps de chauffe et de refroidissement s'en trouve également significativement réduit, ce qui améliore grandement la rapidité du procédé, sa capacité, son rendement, et son coût.

Typiquement, la durée d'un cycle de chauffe (pour atteindre une température comprise par exemple entre 100°C et 200°C) et de refroidissement (pour redescendre par exemple jusqu'à 30°C) passe de quelques minutes, voire quelques dizaines de minutes à quelques secondes.

Avantageusement, lesdites première (22) et seconde (23) surfaces principales peuvent être planes et parallèles.

Avantageusement, lesdites première (22) et seconde (23) surfaces principales peuvent être horizontales et la première surface principale (22) peut être alors définie comme une surface inférieure et la seconde surface principale (23) peut être alors définie comme une surface supérieure.

Avantageusement, le moule selon l'invention peut comprendre en outre des marques de positionnement, alignement (39, 40).

Avantageusement, lesdites marques d'alignement sont situées dans la seconde couche de membrane (30) et/ou dans la couche électriquement et thermiquement isolante (36) et/ou sur ladite couche électriquement et thermiquement isolante (36) au voisinage desdits motifs à imprimer (37).

Ces marques d'alignement, positionnement (39), permettent un alignement, positionnement fin des motifs à imprimer (37), supportés par le moule par rapport à un niveau de référence et à des motifs déjà réalisés sur l'échantillon à imprimer.

Un alignement fin, à savoir avec un écart inférieur à 100 nm est ainsi rendu possible, qui n'était pas jusqu'alors disponible avec les moules massifs en silicium couramment utilisés dans la lithographie par nanoimpression thermique.

Avantageusement, le substrat peut être en un matériau choisi parmi les matériaux compatibles avec les procédés, technologies de micro et nanofabrication tels que le silicium, l'oxyde de silicium, le nitrure de silicium, le germanium, le saphir, le GaAs, et de manière générale, tous les matériaux compatibles avec les technologies dédiées à la microélectronique et aux microtechnologies (« MEMS » par exemple), et les matériaux composites comprenant plusieurs de ces matériaux.

Avantageusement, les première et seconde membranes (29, 30) peuvent être en un matériau choisi parmi les matériaux qui résistent à la gravure anisotrope du matériau du substrat, tels que le Si₃N₄ si le substrat est en Si.

Avantageusement, les moyens de chauffage (34) peuvent être en un matériau choisi parmi le platine, le nitrure de titane, le silicium monocristallin, le silicium polycristallin, et de manière générale, tous les matériaux conducteurs compatibles avec les technologies dédiées à la microélectronique et aux microtechnologies, en d'autres termes, les technologies de micro et de nanofabrication.

Avantageusement, la couche électriquement et thermiquement isolante (36) est en un matériau choisi parmi SiO₂, Si₃N₄, Al₂O₃, HfO₂ et tous les matériaux électriquement et thermiquement isolants compatibles avec les technologies de micro et nanofabrication.

Avantageusement, les motifs à imprimer (37) sont en un matériau choisi parmi Si, SiO₂, Si₃N₄, Al₂O₃, et HfO₂, et tous les matériaux compatibles avec les technologies de micro et nanofabrication.

L'invention concerne, en outre, un procédé de fabrication d'un moule tel qu'il a été décrit plus haut, dans lequel on réalise les étapes successives suivantes :
a) on fournit un substrat (21) comportant une première surface principale (22) et une seconde surface principale (23) ;
b) éventuellement, on forme une couche thermiquement conductrice (33) et de support mécanique dans une zone de la seconde surface principale (23) du substrat (21) ;
c) éventuellement, on dépose une première membrane (29) sur ladite première surface principale (22) ;
d) on dépose une seconde membrane électriquement et thermiquement isolante (30) sur ladite seconde surface principale (23) ;
e) on dépose une couche de résistance chauffante sur la totalité de la surface (35) de la seconde membrane (30);
f) on met en forme la couche de résistance chauffante pour former des moyens de chauffage (34) disposés au-dessus de la couche thermiquement conductrice (33) lorsque celle-ci est présente ;
g) on dépose une couche électriquement et thermiquement isolante (36) sur ladite couche de résistance chauffante mise en forme (34) et sur la seconde membrane (30) ;
h) on réalise des motifs à imprimer (37) sur ladite couche électriquement et thermiquement isolante (36) ;
i) on fabrique au moins une arrivée de courant électrique (38) jusqu'à la couche de résistance chauffante ;
j) éventuellement, on grave la première membrane (29), puis on forme une cavité (24) dans le substrat depuis un premier orifice (27) dans la première surface principale jusqu'à la couche thermiquement conductrice (33) et de support mécanique dans une zone de la seconde surface principale ;
éventuellement, on réalise des marques d'alignement, positionnement, dans la couche de membrane (30) et/ou dans la couche isolante (36) et/ou sur ladite couche électriquement et thermiquement isolante (36) au voisinage des motifs à imprimer (37).

Avantageusement, la ou les arrivée(s) de courant électrique est (sont) fabriquée(s) en gravant au moins un passage traversant la première membrane, éventuellement la seconde membrane, et le substrat et en remplissant ce passage par dépôt électrochimique.

L'invention concerne enfin un procédé de préparation d'un substrat comprenant une surface nanostructurée par une technique de lithographie par nanoimpression thermique dans lequel on met en oeuvre le moule tel que précédemment défini.

Un tel procédé se distingue fondamentalement des procédés de l'art antérieur du fait de la mise en oeuvre du moule spécifique selon l'invention et présente tous les avantages liés de manière inhérente à ce moule et dont la plupart ont été mentionnés plus haut.

L'invention sera mieux comprise à la lecture de la description détaillée qui va suivre, faite à titre illustratif et non limitatif, en référence aux dessins joints dans lesquels :

### BRÈVE DESCRIPTION DES DESSINS

- Les Figures 1A à 1F sont des vues schématiques, en coupe verticale, qui illustrent les étapes successives de la fabrication d'un substrat nanostructuré par un procédé de nanoimpression thermique ;
- la Figure 2A est une vue schématique, de dessus, d'un moule chauffant selon l'invention ;
- la Figure 2B est une vue schématique, en coupe verticale, d'un moule chauffant selon l'invention ;
- la Figure 3A est une vue schématique, de dessus, d'un moule chauffant selon l'invention comprenant des motifs, marques d'alignement, positionnées, au voisinage des motifs à imprimer ;
- la Figure 3B est une vue schématique, en coupe verticale, d'un moule chauffant selon l'invention comprenant des motifs, marques d'alignement, positionnées, au voisinage des motifs à imprimer ;
- la Figure 3C est une vue schématique en coupe verticale d'un moule chauffant selon l'invention avec une structure comprenant des « mesas », les couches (30) et (36), et aussi éventuellement et de préférence, le substrat ayant été gravé pour présenter une surface non utile en retrait ;
- les Figures 4A à 4H sont des vues schématiques, en coupe verticale, qui illustrent les étapes successives de la fabrication d'un moule selon l'invention.

### EXPOSÉ DÉTAILLÉ DE MODES DE RÉALISATION PARTICULIERS

Précisons tout d'abord que dans l'ensemble de la présente description, les termes tels que « sur », « au-dessus » pour définir la position d'un premier élément du moule par rapport à un second élément ne signifient pas que le premier élément est à une altitude plus élevée que le second élément dans un plan vertical, mais ont plutôt simplement pour but de décrire la position relative, du premier élément par rapport au second élément sans que ces deux éléments se situent forcément dans un plan vertical. Il en est de même pour les termes « sous » et « au-dessous » et pour les termes « supérieur » et « inférieur ».

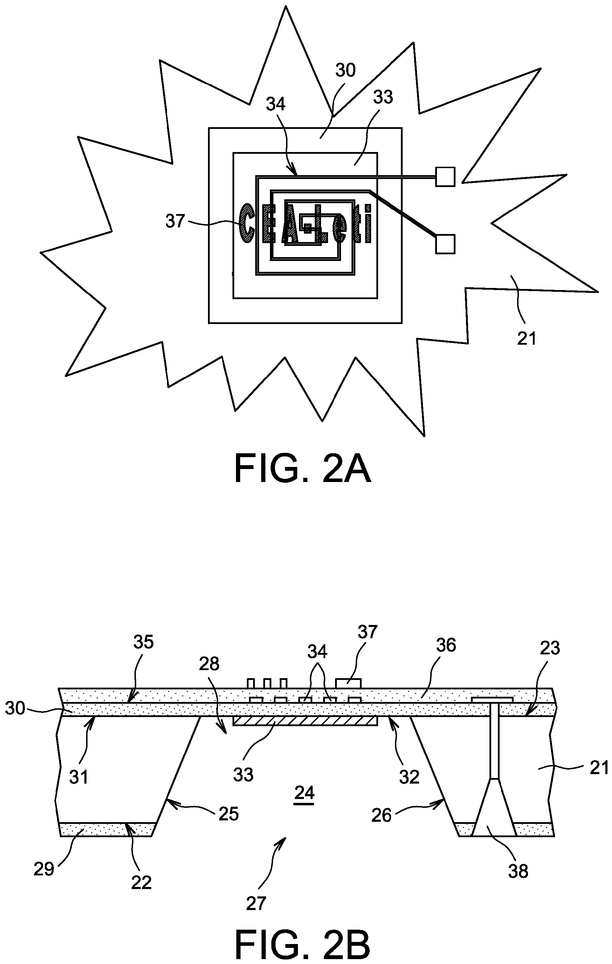

Un moule selon l'invention est représenté sur les figures 2A et 2B.

Il comprend un substrat (21) comportant une première surface principale (22) et une seconde surface principale (23).

Sur la figure 2B, les première (22) et seconde (23) surfaces principales sont planes, parallèles et horizontales. La première surface principale (22) peut donc être définie comme une surface inférieure, tandis que la seconde surface principale (23), peut être définie comme une surface supérieure. Il est bien entendu que cette disposition de la première surface principale (22) et de la seconde principale (23) n'est donnée qu'à titre d'exemple et que d'autres dispositions de ces deux surfaces pourraient être envisagées.

Le substrat (21) peut ainsi avoir la forme d'une plaque ou plaquette comprenant deux surfaces planes, parallèles (22, 23), par exemple carrées, rectangulaires ou encore circulaires.

L'épaisseur du substrat (21) c'est-à-dire la distance entre la première surface principale (22) du substrat (21) et la seconde surface principale (23) du substrat (21) est typiquement comprise entre 350 et 735 µm en fonction de l'épaisseur du substrat choisi.

Le substrat (21) peut être en tout matériau compatible avec les procédés de micro et de nanofabrication tel que le silicium, l'oxyde de silicium, le nitrure de silicium, le germanium, le saphir, le GaAs, et les matériaux composites comprenant plusieurs de ces matériaux.

Un matériau préféré est le silicium.

Une cavité traversante (24) définie par des parois latérales (25, 26) s'étend dans le substrat (21) depuis un premier orifice (27) dans la première surface principale (22) jusqu'à un second orifice (28) dans la seconde surface principale (23).

Cette cavité (24) et donc les deux orifices ont généralement une section circulaire ou rectangulaire selon les procédés de fabrication choisis et le second orifice (28) a généralement une taille inférieure ou égale à la taille du premier orifice (27). Par exemple, le second orifice (28) a généralement un diamètre inférieur au diamètre du premier orifice notamment si la gravure est anisotrope et se fait par voie humide.

Comme cela est représenté sur la figure 2B, la cavité (24) peut ainsi avoir la forme d'un tronc de cône dont les parois latérales (25, 26) convergent depuis la première surface principale (22) jusqu'à la seconde surface principale (23).

Toutefois, le fait que la cavité (24) présente des parois latérales (25, 26) obliques ne présente pas un intérêt particulier et d'autres configurations pourraient être envisagées pour les parois latérales (25, 26) de la cavité (24).

La première surface principale (22) est éventuellement recouverte par une première membrane (29) (sur les figures il s'agit d'une membrane inférieure).

Cette première membrane (29) lorsqu'elle est présente peut recouvrir en totalité ou en partie la première surface principale (22) du substrat, et peut soit laisser totalement libre le premier orifice (27), soit obturer totalement ou en partie ledit premier orifice.

Sur les figures, à titre d'exemple, on a représenté un mode de réalisation dans lequel la première membrane (29) laisse libre ledit premier orifice (27). En d'autres termes, cette première membrane (29) recouvre en totalité ou en partie ladite première surface (22) mais n'obture pas ledit premier orifice (27) et ne va pas au-delà des bords de celui-ci.

La première membrane (29) n'est pas essentielle, ce n'est pas une membrane à proprement parler mais un masque qui permet de faciliter la gravure du substrat pour avoir l'évidement ou cavité (24) .

La cavité (24) peut, dans le moule selon l'invention, être définie comme un évidement dans le cas où le premier orifice (27) est laissé libre (comme sur les figures) ou est seulement obturé en partie. Mais cette configuration de la cavité (24) sous la forme d'un évidement n'est toutefois pas obligatoire, c'est-à-dire que la cavité (24) peut être fermée de part et d'autre, ce qui est le cas lorsque la membrane (29) couvre, obture totalement le premier orifice (27).

Une configuration de la cavité sous la forme d'un évidement est utile quand il y a des marques d'alignement pour positionner la structure.

On pourrait dans ce cas voir à travers l'évidement lorsqu'on positionne la structure.

Si l'alignement n'existe pas, l'évidement n'est pas pertinent. Dans ce cas, on préfère une cavité (24) fermée, et non un évidement traversant.

Le second orifice (28) est obturé par une seconde membrane (30) (sur les figures il s'agit d'une membrane supérieure) qui repose par une de ses faces (31), à savoir la face inférieure dans le cas de la figure 2B, sur ladite seconde surface principale (23) du substrat (21).

Cette seconde membrane (30) recouvre en totalité ou en partie ladite seconde surface (23).

La seconde membrane (30) peut être définie comme un support sur lequel est disposée la couche (36) contenant les moyens de chauffage (34) et qui est surmontée par les motifs (37). Cette membrane (30) est électriquement et thermiquement isolante car les éléments chauffants (34), qui doivent généralement être assez proches des motifs (37) sont noyés dans cette membrane.

Par « assez proches », on entend généralement que les éléments chauffants (34) sont situés généralement à une distance de un à quelques nanomètres (par exemple 2, 3, 5, 10, 20) jusqu'à 100 à quelques centaines de nanomètres (par exemple 200, 300, 500, 1000, 2000 nm) des motifs (37).

Lesdites première et seconde membranes (29, 30) ont généralement une épaisseur de 100 à 200 nm .

Ces première (29) et seconde (30) membranes sont généralement en un matériau choisi parmi les matériaux qui résistent à la gravure du substrat, en particulier parmi les matériaux qui résistent à la gravure anisotrope du substrat en silicium, tel que Si₃N₄.

Il est à noter que la membrane (30) n'est pas forcément utilisée pour arrêter la gravure mais avantageusement, elle peut être utilisée dans ce but.

La partie libre (32) de la face inférieure (31) de ladite seconde membrane (30), du coté du second orifice (28), et qui ne repose donc pas sur la seconde surface principale (23) du substrat (21) comporte éventuellement une couche (33) conductrice thermiquement.

Cette couche (33) est généralement en un matériau choisi parmi Si, les métaux et les semiconducteurs, par exemple la couche (33) peut être en Si ou en TiN. La couche (33) a généralement une épaisseur de 500 nm à 5 µm.

La couche (33) n'est pas essentielle. La couche (33) est thermiquement conductrice et non isolante pour uniformiser la chaleur sur toute la surface au-dessous des moyens de chauffage (34). Mais il peut être souhaitable de rajouter une couche isolante (non représentée) en-dessous de cette couche (33) pour éviter la convexion et que la chaleur ne se diffuse trop dans le substrat (21).

Cette première couche (33) ne recouvre généralement qu'une fraction de la partie libre (32) de la face inférieure (31) de la seconde membrane (30), elle est généralement placée au centre de ladite partie libre, et de manière correspondante au centre dudit second orifice (28).

Des moyens de chauffage (34) sont déposés sur l'autre des faces (35) de ladite membrane (30), dans une zone de ladite seconde membrane au-dessus dudit second orifice (28) de la cavité (24) et au-dessus de ladite première couche éventuelle (33). Ces moyens, éléments de chauffage (34) sont généralement constitués par une couche de résistance chauffante recouvrant au moins en partie ladite zone. Cette couche de résistance chauffante (34) a généralement une épaisseur de 10 à 500 nm.

Cette couche de résistance chauffante présente généralement des motifs, une forme, une géométrie, déterminée dans le plan de la couche.

La position exacte des éléments chauffants (34), leur forme, leur géométrie et leurs dimensions peuvent être facilement déterminées par l'homme du métier en ayant éventuellement recours à des expériences de simulation. Les dimensions des éléments chauffants (34) dépendent en particulier des propriétés thermiques des matériaux du moule et du matériau à imprimer tel qu'une résine ainsi que de la température maximale à atteindre et de la densité des motifs à imprimer.

La forme, géométrie des éléments chauffants (34) détermine la répartition de température, la puissance nécessaire et l'impédance du circuit de chauffe.

Les éléments chauffants (34) peuvent être en un matériau conducteur quelconque, mais des matériaux préférés sont le platine, le nitrure de titane, le silicium mono ou polycristallin, de préférence le silicium mono ou polycristallin dopé, de préférence encore fortement dopé, pour leurs propriétés électriques et leur compatibilité avec les technologies de micro et de nanofabrication.

Une température homogène sur toute la zone de la surface du moule située au-dessus des éléments chauffants, à savoir la région centrale où sont localisés les motifs à imprimer peut être obtenue en optimisant la géométrie de l'élément chauffant. La géométrie de l'élément chauffant montrée sur la figure 2A est un exemple d'une telle géométrie optimisée.

Une température homogène est également obtenue sur toute l'épaisseur de la membrane (30).

La valeur de la température des éléments chauffants (34) peut être maîtrisée par un capteur intégré, généralement réalisé dans le même matériau que les éléments chauffants ou bien en contrôlant précisément la puissance fournie à ces éléments chauffants.

Une couche électriquement et thermiquement isolante (36) recouvre lesdits moyens de chauffage (34) et ladite seconde membrane (30). En d'autres termes, la couche électriquement et thermiquement isolante (36) recouvre lesdits moyens de chauffage (34) dans les parties de la surface (35) de la seconde membrane sur lesquels sont prévus les éléments chauffants (34) ou bien la surface de la seconde membrane (30) dans les parties de la surface (35) de la seconde membrane (30) sur lesquelles ne sont pas prévus d'éléments chauffants (34) .

Cette couche électriquement et thermiquement isolante (36) est généralement en un matériau choisi parmi SiO₂, Si₃N₄, Al₂O₃, et HfO₂. Cette couche électriquement et thermiquement isolante (36) a généralement une épaisseur de 10 à 500 nm.

La couche (36) est isolante thermiquement mais les motifs (37) sont quand même chauffés.

En effet, la couche (36) est généralement suffisamment mince (10 à 500 nm) pour permettre que la diffusion thermique (36) arrive verticalement aux motifs, mais cette épaisseur de la couche ne permet pas la diffusion latérale de la chaleur. La majeure partie de la chaleur est donc utilisée pour chauffer les motifs (37) et non le substrat (21).

Le moule selon l'invention comprend des motifs à imprimer (37) sur ladite couche électriquement et thermiquement isolante (36) dans une zone de ladite couche au-dessus de ladite première couche éventuelle (33) et par voie de conséquence au-dessus dudit second orifice (28) de ladite cavité (24).

Ces motifs (37) du moule sont constitués par une structuration, par exemple par une nanostructuration qui est conforme à la structuration du matériau à imprimer tel qu'une résine organique ou un matériau minéral.

La structuration par exemple la nanostructuration du moule, peut être constituée par un réseau périodique. Ce réseau périodique peut être un réseau à une dimension ou un réseau à deux dimensions.

Un tel réseau à une dimension pourra par exemple être un réseau de lignes avec des motifs périodiques d'une période P et d'une hauteur h. La période P peut être de 10 nm à un ou quelques micromètres, de préférence de 100 nm à 1 µm, de préférence encore de 200 à 600 nm, et la hauteur h peut être d'au moins 5 nm à 500 nm, de préférence de 50 nm à 200 nm.

Si le réseau est un réseau à deux dimensions, il pourra être choisi notamment parmi les réseaux carrés, les réseaux triangulaires, rectangulaires, hexagonaux, et les réseaux plus complexes tels que les réseaux d'Archimède.

Le réseau peut aussi être un réseau de plots.

Il est à noter que la structuration présente généralement des motifs géométriques simples, non arrondis. Par exemple, les lignes peuvent avoir une section transversale triangulaire, rectangulaire ou carrée.

Il est à noter que les moyens de chauffage, éléments chauffants (34) sont généralement assez proches des motifs (37) c'est-à-dire que la distance entre ces moyens de chauffage (34) et ces motifs est généralement dans la plage déjà donnée plus haut, qui peut aller d'un à quelques nanomètres jusqu'à 100 à quelques centaines de nanomètres dans le sens de l'épaisseur.

Le moule selon l'invention comporte, en outre, des moyens pour amener un courant électrique auxdits moyens de chauffage (34).

Avantageusement, ces moyens peuvent être constitués par une ou plusieurs amenées de courant (38) qui traversent les épaisseurs de la première membrane (29) éventuelle (membrane inférieure), du substrat (21), et de la seconde membrane (30) (membrane supérieure) et qui sont électriquement connectés aux éléments chauffants (34).

Avantageusement, comme cela est représenté sur les figures 3A et 3B, le moule selon l'invention peut comporter des marques, structures de positionnement, d'alignement (39).

Ces marques, structures (39) peuvent avoir la forme d'un carré ou d'une croix ou alors elles peuvent prendre la forme de verniers d'alignement comme ceux utilisés dans la lithographie optique par exemple.

En fait, la forme choisie va dépendre du logiciel et de la reconnaissance d'image qui sera effectuée par la suite, donc cela dépendra des caractéristiques de l'équipement utilisé.

En ce qui concerne le matériau de ces marques de positionnement, et du fait que ces marques n'ont pas obligatoirement besoin de chauffer, on utilisera avantageusement des matériaux compatibles avec les procédés de micro et nanofabrication.

Les figures 3A et 3B montrent des marques, structures d'alignement qui sont pratiquées dans la couche électriquement et thermiquement isolante (36) au voisinage des motifs à imprimer (37).

Comme cela est montré sur les figures 3A et 3B, ces marques peuvent être situées généralement à l'extérieur de la zone de la couche isolante (36) sur laquelle se trouvent les motifs à imprimer.

Comme cela est montré sur les figures 3A et 3B, ces marques peuvent se situer en outre généralement au-dessus du second orifice (28) mais non au-dessus de la couche éventuelle (33).

Les marques se trouvent plutôt généralement au-dessus de la fraction de la partie libre (32) de la face inférieure (31) de la seconde membrane (30) qui n'est pas recouverte par la couche optionnelle (33).

Sur la figure 3C, on montre un mode de réalisation du moule chauffant selon l'invention dans lequel en dehors de la zone fonctionnelle les couches (30), (36), et aussi éventuellement et de préférence, le substrat (21) ont été gravés pour que la surface non utile du substrat soit en retrait (« recess »). On peut aussi dire que l'on fait des « mesas ».

Une telle opération limite la surface de contact de la face avant du moule avec la résine, ce qui réduit les défauts et rend le décollage plus facile. Cette configuration de la figure 3C peut également faciliter la fixation du moule sur le support de la machine.

Plus précisément, on appelle « zone fonctionnelle » la zone de ces couches et du substrat qui comprend et/ou supporte les moyens de chauffage, éléments chauffants (34), les motifs à imprimer (37), les moyens pour amener un courant électrique (38) aux moyens de chauffage (34) et les marques de positionnement, alignement, éventuelles (39, 40).

Les couches (36) et (30) sont gravées sur toute leur épaisseur et le substrat peut être gravé sur une épaisseur de une à quelques dizaines de nanomètres (par exemple 20, 30, 40 , 50 nm) jusqu'à une à quelques centaines de nanomètres (par exemple 200, 300, 400, 500 nm) (figure 3C).

Les différentes étapes d'un procédé pour la fabrication du moule selon l'invention sont illustrées sur les figures 4A à 4H.

Dans une première étape, montrée sur la Figure 4A, on prépare sur le substrat (21) dans une zone définie de la seconde surface (qui peut être une surface supérieure) de celui-ci (23), la couche thermiquement conductrice (33) qui servira de support mécanique à la membrane (30), et qui permettra aussi d'uniformiser la température de la zone d'impression.

Cette couche (33) peut être réalisée en effectuant un dopage sélectif du matériau du substrat tel que du silicium, par implantation ionique notamment d'ions N⁺ puis recuit, ou bien par diffusion. On obtient ainsi par exemple une couche (33) en SiN.

Ces couches fortement dopées ont la propriété de ne pas être attaquées lors de la gravure anisotrope du Si.

Dans une deuxième étape, montrée sur la figure 4B, on dépose une couche de membrane (29, 30) en un matériau (tel que du Si₃N₄) résistant aux gravures anisotropes du matériau du substrat sur la totalité de la surface des deux faces (22, 23) du substrat (21).

Dans une troisième étape, montrée sur la figure 4C, on dépose sur la totalité de la surface supérieure (35) de la seconde membrane (supérieure) une couche de résistance chauffante (34) par exemple en un métal tel que le platine, le nitrure de titane ou en polysilicium. On procède ensuite à la mise en forme de la résistance par photolithographie et gravure sèche ou humide. Cette mise en forme permet de donner à la résistance la géométrie voulue, éventuellement optimisée, telle que celle montrée (34) sur les figures 2B et 3B.

Dans une quatrième étape, montrée sur la figure 4D, on dépose une couche thermiquement et électriquement isolante (36), par exemple en un matériau tel que SiO₂, Si₃N₄, Al₂O₃ ou HfO₂ sur les éléments chauffants (34) et sur la seconde couche de membrane (30). Cette couche isolante (36) peut être éventuellement constituée par plusieurs couches, chacune de ces couches étant éventuellement en un matériau différent.

A l'issue du dépôt de la couche isolante (36), on réalise généralement un traitement de planarisation de la couche déposée par polissage chimico-mécanique (CMP).

Dans une cinquième étape, montrée sur la figure 4E, on réalise les motifs à imprimer (37) (structurations, nanostructurations) sur la couche isolante (36).

Avantageusement, ces motifs (37) sont fabriqués par structuration d'une couche mince par exemple en Si, SiO₂, Si₃N₄, Al₂O₃, HfO₂ ou d'une multicouche, généralement par photolithographie et gravure sélective.

Dans une sixième étape, montrée sur la figure 4F, on fabrique les arrivées, amenées de courant vers les éléments chauffants.

Pour cela, on peut avantageusement réaliser une gravure profonde du substrat, par exemple en utilisant la technique dite « deep RIE » (pour « Reactive Ion Etching ») de façon à créer un passage ou « via », traversant dans le sens de l'épaisseur les deux membranes et le substrat.

Ce passage ou « via » est ensuite rempli d'un matériau conducteur tel que le cuivre par dépôt électrochimique.

Dans une septième étape, montrée sur la figure 4G, la membrane inférieure ou couche de protection, par exemple en Si₃N₄, est généralement tout d'abord structurée par lithographie et gravure sèche. Ensuite on libère la membrane supérieure (30) par gravure anisotrope, par exemple avec de la potasse KOH ou de l'hydroxyde de tétraméthyl ammonium TMAH ou TMAOH, du matériau du substrat (21) depuis la surface inférieure ou face arrière (22) de ce substrat.

Le procédé peut éventuellement comprendre une huitième étape si l'on souhaite fabriquer un substrat tel que celui représenté sur les figures 3A et 3B au cours de laquelle on réalise des marques (39) de positionnement, alignement, par exemple dans la couche isolante (36) au voisinage des motifs à imprimer (37).

De manière générale, les marques peuvent être réalisées à la fin ou en même temps que la réalisation des couches (30), (34) et des motifs (37). Elles peuvent être faites dans la couche (30) ou dans la couche (36) et voire même au niveau des motifs (37) (à condition que la taille de ces marques (39) soit inférieure à la taille des motifs (37)) : c'est ce mode de réalisation qui est montré sur la figure 3B.

Les marques peuvent être éventuellement en relief ou de creux, en d'autres termes, les marques peuvent être des bosses ou des trous.

La figure 4H est une variante de la troisième étape montrée sur la figure 4C, dans laquelle on réalise une série de marques (40) de positionnement, alignement, sur la couche de membrane supérieure (30) au voisinage des éléments chauffants (34) mis en forme. Ces marques (39, 40) peuvent être ensuite utilisées pour aligner les structures aux niveaux précédents.

Le procédé de fabrication suit ensuite les mêmes étapes que celles décrites précédemment (Figures 4D à 4G).

De manière générale, ces marques (39, 40) peuvent être réalisées durant la mise en forme de la résistance chauffante en structurant la couche conductrice (34) même, mais elles peuvent aussi être superposées sur la surface du moule, généralement sur la couche (36), en déposant une couche opaque, comme par exemple une couche en silicium, qui est ensuite structurée par une étape de lithographie et de gravure sélective pour donner les marques (39).

Le moule selon l'invention peut être utilisé dans un procédé de fabrication d'un substrat comprenant une surface nanostructurée par une technique de lithographie par nanoimpression thermique.

Un tel procédé pourra par exemple comprendre les étapes successives suivantes :
a) on dépose une couche d'une résine organique ou d'un matériau minéral à faible température de fusion sur une surface plane d'un substrat ;
b) on chauffe la résine organique jusqu'à une température supérieure ou égale à sa température de transition vitreuse Tg ou à sa température de fusion, ou on chauffe le matériau minéral jusqu'à une température supérieure ou égale à sa température de fusion, et on imprime la couche de résine organique ou de matériau minéral liquide avec le moule selon l'invention présentant une nanostructuration, moyennant quoi la couche de résine organique ou de matériau minéral est munie d'une première nanostructuration conforme à la nanostructuration du moule ;
c) on abaisse la température de la résine organique ou du matériau minéral jusqu'à une température à laquelle il/elle est solide ;
d) on sépare le moule de la couche de résine organique ou de matériau minéral solidaire du substrat.

L'invention va maintenant être décrite en référence aux exemples suivants, donnés à titre illustratif et non limitatif.

### Exemple :

Dans cet exemple, on décrit la préparation d'un moule selon l'invention par un procédé selon l'invention tel qu'il est illustré sur les Figures 4A à 4H.
1) On commence, comme sur la Figure 4A, par réaliser un masque de résine avec des procédés classiques de la micro-électronique (typique du niveau implantation). La résine fait au moins 500 nm d'épaisseur et permet de mettre à nu une certaine (ou certaines) zone(s) du substrat qui seront implantées. Cette(ces) zone(s) permettra(permettront) d'uniformiser localement la chauffe de la zone dite active.
   On procède à un dopage sélectif n++, par exemple par implantation ionique de P environ 200 KeV, 10⁺¹⁵ a/cm² , et traitement thermique RTP 1100°C pendant environ 30 secondes, zone au-dessous de la membrane.
2) On dépose ensuite, comme sur la figure 4B, une couche de membrane résistante aux gravures anisotropes du Si (typiquement du Si₃N₄) . Il s'agit d'un dépôt pleine plaque sur les deux faces du substrat d'une épaisseur de 100-200 nm.
3) On réalise ensuite, comme sur la figure 4C, le dépôt pleine plaque d'une couche de résistance chauffante, avantageusement du Pt (50 nm) ou du TiN (150 nm) suivi par mise en forme de la résistance par un procédé de photolithographie « e-beam » (avec 150 nm de résine) par exemple, pour avoir des dimensions « sub 100 nm » et gravure sèche ionique (« IBE/RIE »). On définit ainsi la forme des motifs chauffants.
4) On dépose ensuite, comme sur la Figure 4D, une couche isolante, typiquement du SiO₂. L'épaisseur de cette couche est supérieure à l'épaisseur de la couche conductrice gravée, typiquement de 2 à 3 fois la hauteur de la marche. Le dépôt est suivi par une étape de planarisation par CMP pour obtenir une couche plane.
5) On réalise ensuite, comme sur la Figure 4E, des motifs à imprimer. Avantageusement, les motifs sont fabriqués par structuration d'une couche mince de Si de 100 nm d'épaisseur par lithographie électronique pour avoir des résolutions « sub 100 nm » et gravure sélective.
6) On réalise, comme sur la Figure 4F, une lithographie optique en face arrière du substrat pour graver localement la couche déposée lors de l'étape 2), puis on grave l'intégralité de l'épaisseur du substrat de Si avec des procédés de gravure profonde. On arrête la gravure au niveau de la couche conductrice mise en forme lors de l'étape 3). On réalise ensuite un dépôt électrolytique de cuivre pour remplir le trou ainsi obtenu et pour obtenir une connexion électrique entre la face arrière et le circuit de chauffe.
7) On libère, comme sur la Figure 4G, la membrane par gravure de la couche de protection réalisée lors de l'étape 2) puis par une gravure anisotrope avec KOH ou TMAH du Si en face arrière. Cette étape de gravure dure généralement plusieurs heures suivant la température et la concentration du bain. La gravure est arrêtée sur la couche déposée lors de l'étape 2). La couche de protection en face arrière (typiquement Si₃N₄) est structurée par lithographie et gravure sèche.

## Revendications

1. Moule chauffant pour la lithographie par nanoimpression thermique comprenant :
- un substrat (21) comportant une première surface principale (22) et une seconde surface principale (23), et une cavité traversante (24) s'étendant depuis un premier orifice (27) dans la première surface principale (22) jusqu'à un second orifice (28) dans la seconde surface principale (23), ladite première surface principale (22) étant éventuellement au moins en partie recouverte par une première membrane (29) obturant totalement ou en partie ou bien laissant libre ledit premier orifice (27), et ledit second orifice (28) étant totalement obturé par une seconde membrane électriquement et thermiquement isolante (30) reposant par une première de ses faces (31) sur ladite seconde surface principale (23) et recouvrant au moins en partie ladite seconde surface (23) ;
- éventuellement, une couche (33) thermiquement conductrice et de support mécanique de la seconde membrane (30) sur ladite première face (31) de la seconde membrane (30) au-dessus (32) dudit second orifice (28) ;
- éventuellement, une couche thermiquement isolante sous ladite couche (33) thermiquement conductrice et de support mécanique ;
- des moyens de chauffage (34) sur l'autre des faces (35) de ladite seconde membrane (30) dans une zone de ladite seconde membrane (30) au-dessus dudit second orifice (28) ;
- une couche électriquement et thermiquement isolante (36) qui recouvre lesdits moyens de chauffage (34) et au moins partiellement ladite seconde membrane (30) ;
- des motifs à imprimer (37) sur ladite couche électriquement et thermiquement isolante (36) dans une zone de ladite couche électriquement et thermiquement isolante (36) au-dessus dudit second orifice (28) ;
- des moyens (38) pour amener un courant électrique auxdits moyens de chauffage (34).

2. Moule selon la revendication 1, dans lequel lesdites première (22) et seconde (23) surfaces principales sont planes et parallèles.

3. Moule selon la revendication 2, dans lequel lesdites première (22) et seconde (23) surfaces principales sont horizontales.

4. Moule selon l'une quelconque des revendications précédentes, comprenant en outre des marques de positionnement, alignement (39, 40).

5. Moule selon la revendication 4, dans lequel lesdites marques d'alignement sont situées dans la seconde membrane (30) et/ou dans la couche électriquement et thermiquement isolante (36) et/ou sur ladite couche électriquement et thermiquement isolante (36) au voisinage des motifs à imprimer (37).

6. Moule selon l'une quelconque des revendications précédentes, dans lequel le substrat est en un matériau choisi parmi les matériaux compatibles avec les procédés de micro et nanofabrication tels que le silicium, l'oxyde de silicium, le nitrure de silicium, le germanium, le saphir, le GaAs, et les matériaux composites comprenant plusieurs de ces matériaux.

7. Moule selon l'une quelconque des revendications précédentes, dans lequel les première (29) et seconde (30) membranes sont en un matériau choisi parmi les matériaux qui résistent à la gravure anisotrope du matériau du substrat tels que le Si₃N₄ si le substrat est en silicium.

8. Moule selon l'une quelconque des revendications précédentes, dans lequel les moyens de chauffage (34) sont en un matériau choisi parmi le platine, le nitrure de titane, le silicium monocristallin, le silicium polycristallin, et tous les matériaux conducteurs compatibles avec les technologies de micro et nanofabrication.

9. Moule selon l'une quelconque des revendications précédentes, dans lequel la couche électriquement et thermiquement isolante (36) est en un matériau choisi parmi SiO₂, Si₃N₄, Al₂O₃, HfO₂ et tous les matériaux électriquement et thermiquement isolants compatibles avec les technologies de micro et nanofabrication.

10. Moule selon l'une quelconque des revendications précédentes, dans lequel les motifs à imprimer (37) sont en un matériau choisi parmi Si, SiO₂, Si₃N₄, Al₂O₃, HfO₂ et tous les matériaux compatibles avec les technologies de micro et nanofabrication .

11. Procédé de préparation d'un moule selon l'une quelconque des revendications 1 à 10, dans lequel on réalise les étapes successives suivantes :
a) on fournit un substrat (21) comportant une première surface principale (22) et une seconde surface principale (23) ;
b) éventuellement, on forme une couche thermiquement conductrice (33) et de support mécanique dans une zone de la seconde surface principale (23) du substrat (21) ;
c) éventuellement, on dépose une première membrane (29) sur ladite première surface principale (22) ;
d) on dépose une seconde membrane électriquement et thermiquement isolante (30) sur ladite seconde surface principale (23) ;
e) on dépose une couche de résistance chauffante sur la totalité de la surface (35) de la seconde membrane (30) ;
f) on met en forme la couche de résistance chauffante pour former des moyens de chauffage (34) disposés au-dessus de la couche thermiquement conductrice (33) lorsque celle-ci est présente ;
g) on dépose une couche électriquement et thermiquement isolante (36) sur ladite couche de résistance chauffante mise en forme (34) et sur la seconde membrane (30) ;
h) on réalise des motifs à imprimer (37) sur ladite couche électriquement et thermiquement isolante (36) ;
i) on fabrique au moins une arrivée de courant électrique (38) jusqu'à la couche de résistance chauffante ;
j) on grave éventuellement la première membrane (29), puis on forme une cavité (24) dans le substrat depuis un premier orifice (27) dans la première surface principale jusqu'à la couche thermiquement conductrice et de support mécanique (33) dans une zone de la seconde surface principale ;
éventuellement, on réalise des marques d'alignement, positionnement, dans la couche de membrane (30) et/ou dans la couche isolante (36) et/ou sur ladite couche électriquement et thermiquement isolante (36) au voisinage des motifs à imprimer (37).

12. Procédé selon la revendication 11, dans lequel la ou les arrivée(s) de courant électrique est(sont) fabriquée(s) en gravant au moins un passage traversant la première membrane, éventuellement la seconde membrane, et le substrat et en remplissant ce passage par dépôt électrochimique.

13. Procédé de préparation d'un substrat comprenant une surface nanostructurée par une technique de lithographie par nanoimpression thermique dans lequel on met en oeuvre le moule selon l'une quelconque des revendications 1 à 10.

## Patentansprüche

1. Heizform für die Lithographie durch thermische Nanoprägung, umfassend :
- ein Substrat (21) mit einer ersten Hauptfläche (22) und einer zweiten Hauptfläche (23), und einem durchgehenden Hohlraum (24), der sich von einer ersten Öffnung (27) in der ersten Hauptfläche (22) bis zu einer zweiten Öffnung (28) in der zweiten Hauptfläche (23) erstreckt, wobei die genannte erste Hauptfläche (22) gegebenenfalls wenigstens zum Teil mit einer ersten Membran (29) bedeckt ist, welche die erste Öffnung (27) ganz oder teilweise verschließt oder frei lässt, und die zweite Öffnung (28) ganz verschlossen ist durch eine elektrisch und thermisch isolierende Membran (30), die mit einer ersten (31) ihrer Seiten auf der genannten zweiten Hauptfläche (23) ruht und wenigstens teilweise die genannte zweite Fläche (23) bedeckt;
- eventuell eine thermisch leitende und die Membran (30) mechanisch unterstützende Schicht (33) auf der genannten ersten Seite (31) der zweiten Membran (30) über (32) der genannten zweiten Öffnung (28) ;
- eventuell eine thermisch isolierende Schicht unter der genannten thermisch leitenden und mechanisch unterstützenden Schicht (33) ;
- Heizeinrichtungen (34) auf der anderen Seite (35) der genannten zweiten Membran (30) in einer Zone der genannten zweiten Membran (30) über der genannten zweiten Öffnung (28) ;
- eine elektrisch und thermisch isolierende Schicht (36), welche die genannten Heizeinrichtungen (34) und wenigstens partiell die genannte zweite Membran bedeckt;
- Muster (37), zu drucken auf die genannte elektrisch und thermisch isolierende Schicht (36) in einer Zone der genannten elektrisch und thermisch isolierenden Schicht (36) über der genannten zweiten Öffnung (28) ;
- Einrichtungen (38), um den genannten Heizeinrichtungen (34) elektrischen Strom zuzuführen.

2. Form nach Anspruch 1, bei der die genannten ersten (22) und zweiten (23) Hauptflächen plan und parallel sind.

3. Form nach Anspruch 2, bei der die genannten ersten (22) und zweiten (23) Hauptflächen horizontal sind.

4. Form nach einem der vorhergehenden Ansprüche, mit außerdem Marken zur Positionierung, Ausrichtung (39, 40).

5. Form nach Anspruch 4, bei der die genannten Ausrichtungsmarken sich in der zweiten Membran (30) und/oder in der elektrisch und thermisch isolierenden Schicht (36) und/oder auf der genannten elektrisch und thermisch isolierenden Schicht (36) in der Nähe der zu prägenden Muster (37) befinden.

6. Form nach einem der vorhergehenden Ansprüche, bei der das Substrat aus einem unter denjenigen Materialien ausgewählten Material ist, die kompatibel sind mit den Mikro- und Nanofabrikationsverfahren, wie dem Silicium, dem Siliciumoxid bzw. -dioxid, dem Siliciumnitrid, dem Germanium, dem Saphir, dem GaAs, und den mehrere dieser Materialien umfassenden Kompositmaterialien.

7. Form nach einem der vorhergehenden Ansprüche, bei der die ersten (29) und zweiten (30) Membranen aus einem Material sind, das ausgewählt wird unter den Materialien, die resistent sind gegen das anisotrope Ätzen des Materials des Substrats, wie dem Si₃N₄, wenn das Substrat aus Silicium ist.

8. Form nach einem der vorhergehenden Ansprüche, bei der die Heizeinrichtungen (34) aus einem Material sind, das ausgewählt wird unter Platin, Titannitrid, monokristallinem Silicium, polykristallinem Silicium und allen mit den Mikro- und Nanofabrikationstechniken kompatiblen leitfähigen Materialien.

9. Form nach einem der vorhergehenden Ansprüche, bei der die elektrisch und thermisch isolierende Schicht (36) aus einem Material ist, das ausgewählt wird unter SiO₂, Si₃N₄, Al₂O₃, HfO₂ und allen elektrisch und thermisch isolierenden Materialien, die kompatibel sind mit den Mikro- und Nanofabrikationstechniken.

10. Form nach einem der vorhergehenden Ansprüche, bei der die zu prägenden Muster (37) aus einem Material sind, das ausgewählt wird unter Si, SiO₂, Si₃N₄, Al₂O₃, HfO₂ und allen mit den Mikro- und Nanofabrikationstechniken kompatiblen Materialien.

11. Verfahren zur Herstellung einer Form nach einem der Ansprüche 1 bis 10, bei dem man die folgenden sukzessiven Schritte ausführt :
a) man besorgt ein Substrat (21) mit einer ersten Hauptfläche (22) und einer zweiten Hauptfläche (23) ;
b) eventuell bildet man eine thermisch leitende und mechanisch unterstützende Schicht (33) in einer Zone der zweiten Hauptfläche (23) des Substrats (21) aus ;
c) eventuell scheidet man eine erste Membran (29) auf der genannten ersten Hauptfläche (22) ab ;
d) man scheidet eine zweite, elektrisch und thermisch isolierende Membran(30) auf der genannten zweiten Hauptfläche (23) ab ;
e) man scheidet eine Heizwiderstandsschicht auf der Gesamtheit der Oberfläche (35) der zweiten Membran (30) ab ;
f) man formt die Heizwiderstandsschicht um Heizeinrichtungen (34) auszubilden, angeordnet über der thermisch leitenden Schicht (33), wenn diese vorhanden ist;
g) man scheidet eine elektrisch und thermisch isolierende Schicht (36) auf der genannten geformten Heizwiderstandsschicht (34) und auf der zweiten Membran (30) ab ;
h) man realisiert zu prägende Muster (37) auf der genannten elektrisch und thermisch isolierenden Schicht (36) ;
i) man realisiert wenigstens einen Zugang (38) für den elektrischen Strom bis zu der Heizwiderstandsschicht ;
j) man ätzt eventuell die erste Membran (29) und formt dann in dem Substrat einen Hohlraum (24) von einer ersten Öffnung (27) in der ersten Hauptfläche bis zu der thermisch leitenden und mechanisch unterstützenden Schicht (33) in einer Zone der zweiten Hauptfläche ;
eventuell realisiert man Marken zur Ausrichtung, Positionierung, in der Membranschicht (30) und/oder in der isolierenden Schicht (36) und/oder auf der genannten elektrisch und thermisch isolierenden Schicht (36) in der Nähe der zu prägenden Muster (37).

12. Verfahren nach Anspruch 11, bei dem der (die) Zugang (Zugänge) für den elektrischen Strom realisiert werden, indem man mindestens einen die erste Membran, eventuell die zweite Membran, und das Substrat durchquerenden Durchgang realisiert und diesen Durchgang durch elektrochemische Abscheidung füllt.

13. Verfahren zur Herstellung eines Substrats mit einer mittels Lithographietechnik durch thermische Nanoprägung nanostrukturierten Oberfläche, bei dem man die Form nach einem der Ansprüche 1 bis 10 verwendet.

## Claims

1. Heating mould for thermal nanoimprint lithography comprising:
- a substrate (21) having a first principal surface (22) and a second principal surface (23), and a through-cavity (24) extending from a first orifice (27) in the first principal surface (22) up to a second orifice (28) in the second principal surface (23), said first principal surface (22) being, optionally, at least partially covered by a first membrane (29) completely or partially closing off said first orifice (27), or even leaving said first orifice (27) free, and said second orifice (28) being completely closed off by a second electrically and thermally insulating membrane (30) resting with a first of its sides (31) on said second principal surface (23) and at least partially covering said second surface (23);
- optionally, a thermally conducting layer (33) that mechanically supports the second membrane (30) on said first side (31) of the second membrane (30) above (32) said second orifice (28);
- optionally, a thermally insulating layer beneath said thermally conducting and mechanical support layer (33);
- heating means(34) on the other of the sides (35) of said second membrane (30) in a zone of said second membrane (30) above said second orifice (28);
- a electrically and thermally insulating layer (36) which covers said heating means (34) and, at least partially, said second membrane (30);
- imprint patterns (37) on said electrically and thermally insulating layer (36) in a zone of said electrically and thermally insulating layer (36) above said second orifice (28); and
- means (38) for supplying an electric current to said heating means (34).

2. Mould according to Claim 1, in which said first (22) and second (23) principal surfaces are planar and parallel.

3. Mould according to Claim 2, in which said first (22) and second (23) principal surfaces are horizontal.

4. Mould according to any one of the preceding claims, furthermore comprising alignment marks (39, 40).

5. Mould according to Claim 4, in which said alignment marks are located in the second membrane (30) and/or in said electrically and thermally insulating layer (36) and/or on said electrically and thermally insulating layer (36) near the imprint patterns (37).

6. Mould according to any one of the preceding claims, in which the substrate is made of a material chosen from materials compatible with microfabrication and nanofabrication processes, such as silicon, silicon oxide, silicon nitride, germanium, sapphire, GaAs, and composite materials comprising several of these materials.

7. Mould according to any one of the preceding claims, in which the first (29) and second (30) membranes are made of a material chosen from materials resistant to the anisotropic etching of the substrate material, such as Si₃N₄ if the substrate is made of silicon.

8. Mould according to any one of the preceding claims, in which the heating means (34) are made of a material chosen from platinum, titanium nitride, single-crystal silicon, polycrystalline silicon and all the conductive materials compatible with microfabrication and nanofabrication technologies.

9. Mould according to any one of the preceding claims, in which the electrically and thermally insulating layer (36) is made of a material chosen from SiO₂, Si₃N₄, Al₂O₃, HfO₂, and all the electrically and thermally insulating materials compatible with microfabrication and nanofabrication technologies.

10. Mould according to any one of the preceding claims, in which the imprint patterns (37) are made of a material chosen from Si, SiO₂, Si₃N₄, Al₂O₃, HfO₂, and all the materials compatible with microfabrication and nanofabrication technologies.

11. Process for producing a mould according to any one of Claims 1 to 10, in which the following steps are performed in succession:
a) a substrate (21) having a first principal surface (22) and a second principal surface (23) is provided;
b) optionally, a thermally conducting and mechanical support layer (33) is formed in a zone of the second principal surface (23) of the substrate (21);
c) optionally, a first membrane (29) is deposited on said first principal surface (22);
d) a second electrically and thermally insulating membrane (30) is deposited on said second principal surface (23);
e) an electrically resistive heating layer is deposited on the entirety of the surface (35) of the second membrane (30);
f) the electrically resistive heating layer is shaped to form heating means (34) arranged above the thermally conducting layer (33) when said layer is present;
g) an electrically and thermally insulating layer (36) is deposited on said shaped, electrically resistive heating layer (34) and onto the second membrane (30);
h) imprint patterns (37) are produced on said electrically and thermally insulating layer (36);
i) at least one lead (38) for supplying electric current to the electrically resistive heating layer is made;
j) optionally, the first membrane (29) is etched, then a cavity (24) is formed in the substrate from a first orifice (27) in the first principal surface up to the thermally conducting and mechanical support layer (33), in a zone of the second principal surface;
optionally, alignment, positioning marks are produced in the membrane layer (30) and/or in the insulating layer (36) and/or on said electrically and thermally insulating layer (36) near the imprint patterns (37).

12. Process according to Claim 11, in which the lead (or leads) for supplying electric current is (or are) fabricated by etching at least one via through the first membrane, optionally through the second membrane, and through the substrate, and by filling this via by electrodeposition.

13. Process for producing a substrate comprising a nanostructured surface by thermal nanoimprint lithography, in which the mould according to any one of Claims 1 to 10 is employed.
